# EUROPÄISCHE PATENTSCHRIFT

(11) **EP 3 259 785 B1**
(45) Veröffentlichungstag und Bekanntmachung des Hinweises auf die Patenterteilung: **05.12.2018**
(21) Anmeldenummer: 16701458.8
(22) Anmeldetag: 22.01.2016
(51) Int. Cl.: H01L 35/30

(54) **WÄRMELEITENDE UND ELEKTRISCH ISOLIERENDE VERBINDUNG FÜR EIN THERMOELEKTRISCHES MODUL**
HEAT-CONDUCTIVE AND ELECTRICALLY INSULATING CONNECTION FOR A THERMOELECTRIC MODULE
LIAISON THERMOCONDUCTRICE ET ÉLECTRIQUEMENT ISOLANTE POUR UN MODULE THERMOÉLECTRIQUE

(30) Priorität: 19.02.2015 DE 102015202968
(43) Veröffentlichungstag der Anmeldung: 27.12.2017
(73) Patentinhaber: Mahle International GmbH, 70376 Stuttgart (DE)
(72) Erfinder: HIMMER, Thomas, 73326 Reichenbach (Deggingen) (DE); LÄMMLE, Christopher, 70439 Stuttgart (DE)
(74) Vertreter: BRP Renaud & Partner mbB Rechtsanwälte Patentanwälte Steuerberater
(86) Internationale Anmeldenummer: PCT/EP2016/051343
(87) Internationale Veröffentlichungsnummer: WO 2016/131606

(56) Entgegenhaltungen:
- DE-A1-102008 005 694
- DE-A1-102011 079 467
- DE-A1-102012 214 701
- DE-A1-102013 105 292
- US-A1- 2014 305 480

## Beschreibung

Die vorliegende Erfindung betrifft eine wärmeleitende und elektrisch isolierende Verbindung zum Befestigen eines thermoelektrischen Elements an einer Außenwand, die eine Kaltseite oder eine Heißseite eines thermoelektrischen Moduls bildet, das in einem Modulinnenraum mehrere solche thermoelektrische Elemente aufweist, gemäß dem Oberbegriff des Anspruchs 1. Die Erfindung betrifft außerdem ein thermoelektrisches Modul, bei dem wenigstens ein thermoelektrisches Element mit Hilfe einer derartigen Verbindung zumindest an einer Außenwand des thermoelektrischen Moduls befestigt ist. Schließlich betrifft die vorliegende Erfindung ein Verfahren zum Herstellen einer derartigen Verbindung bzw. eines derartigen thermoelektrischen Moduls.

Ein thermoelektrisches Modul weist mehrere thermoelektrische Elemente in Form von positiv und negativ dotierten thermoelektrischen Halbleitermaterialien auf, die über mehrere Leiterbrücken elektrisch verschaltet sind. Das thermoelektrische Modul weist an seiner Kaltseite eine Außenwand auf, die als Kaltseitenwand bezeichnet werden kann und die mit mehreren kaltseitigen Leiterbrücken wärmeleitend, elektrisch isoliert und fest verbunden ist. Analog dazu weist das thermoelektrische Modul an seiner Warmseite eine Außenwand auf, die eine Warmseitenwand bildet, die mit mehreren warmseitigen Leiterbrücken wärmeleitend, elektrisch isoliert und fest verbunden ist. Die thermoelektrischen Elemente sind dabei zwischen Kaltseitenwand und Warmseitenwand angeordnet, so dass sie sich zwischen den kaltseitigen und warmseitigen Leiterbrücken erstrecken.

Ein derartiges thermoelektrisches Modul ist beispielsweise aus der DE 15 39 322 A1 bekannt.

Derartige thermoelektrische Module kommen zum Einsatz, um Temperaturdifferenzen in eine elektrische Potentialdifferenz, also in eine elektrische Spannung, umzuwandeln. Hierdurch lässt sich ein Wärmestrom in einen elektrischen Strom umwandeln. Genutzt wird hierbei der sogenannte Seebeck-Effekt, der einer Umkehrung des sogenannten Peltier-Effekts entspricht. Beispielsweise können derartige thermoelektrische Module zur Abwärmenutzung verwendet werden, beispielsweise bei einer Brennkraftmaschine. Überschüssige Abwärme, z.B. im Abgas, besitzt beispielsweise gegenüber einer Umgebung oder gegenüber einem Kühlmittel eine Temperaturdifferenz, wodurch ein Wärmestrom erzeugt werden kann, der mit Hilfe derartiger thermoelektrischer Module in einen elektrischen Strom umgewandelt werden kann, was besagter Abwärmenutzung entspricht.

Problematisch bei thermoelektrischen Modulen sind die unterschiedlichen thermischen Ausdehnungskoeffizienten der einzelnen, darin angeordneten und miteinander verbundenen Komponenten. Hinzu kommt bei Fahrzeuganwendungen eine hohe Lastwechselfrequenz hinsichtlich der auftretenden Temperaturen. Entscheidend für einen hohen Wirkungsgrad eines derartigen thermoelektrischen Moduls ist außerdem eine dauerhafte feste Verbindung einerseits zwischen den thermoelektrischen Elementen und den Leiterbrücken und andererseits zwischen den Leiterbrücken und der jeweiligen Außenwand, um einen guten Wärmefluss innerhalb des thermoelektrischen Moduls zu erzielen. Bevorzugt kommen dabei metallische Werkstoffe zum Einsatz, da sich diese durch eine hohe Wärmeleitfähigkeit auszeichnen. Dementsprechend bestehen die Außenwände, die Leiterbrücken und die thermoelektrischen Elemente aus metallischen Werkstoffen. Zur Vermeidung eines Kurzschlusses innerhalb des thermoelektrischen Moduls ist es jedoch erforderlich, zwischen den Außenwänden und den Leiterbrücken eine elektrische Isolation vorzusehen. An eine derartige elektrische Isolation werden nun sich widerstrebende Anforderungen gestellt. Sie muss einerseits effizient elektrisch isolieren, während sie andererseits eine gute thermische Leitfähigkeit besitzen soll. Gleichzeitig muss sie sich fest und dauerhaft mit der jeweiligen Außenwand und mit der jeweiligen Leiterbrücke verbinden lassen.

Eine gattungsgemäße Verbindung ist z.B. aus der DE 10 2011 079 467 A1 bekannt. Sie weist eine elektrische Isolationsschicht, die mit der Außenwand fest verbunden ist und die durch ein Dielektrikum gebildet ist, sowie eine elektrisch leitende Metallschicht auf, die mit der Isolationsschicht fest verbunden ist.

Aus der US 2014/0305480 A1 ist ein Dielektrikum bekannt, das auf einem Polymer-basierten System mit nicht-metallischen Festkörperpartikeln beruht.

Aus der DE 10 2012 214 701 A1 ist eine segmentierte Außenwand bekannt.

Die vorliegende Erfindung beschäftigt sich mit dem Problem, für ein thermoelektrisches Modul einen Weg für eine dauerhafte wärmeleitende und elektrisch isolierende Verbindung zwischen einer Außenwand und einem thermoelektrischen Element anzugeben. Ferner soll eine Möglichkeit aufgezeigt werden, eine derartige Verbindung bzw. ein derartiges thermoelektrisches Modul kostengünstig herzustellen.

Dieses Problem wird erfindungsgemäß durch die Gegenstände der unabhängigen Ansprüche gelöst. Vorteilhafte Ausführungsformen sind Gegenstand der abhängigen Ansprüche.

Die Erfindung beruht auf dem allgemeinen Gedanken, die wärmeleitende und elektrisch isolierende Verbindung mit Hilfe einer durch ein Dielektrikum gebildeten elektrisch isolierenden Isolationsschicht und mit Hilfe einer elektrisch leitenden Metallschicht aufzubauen, wobei die Isolationsschicht fest mit der jeweiligen Außenwand verbunden ist, während die Metallschicht fest mit der Isolationsschicht verbunden ist. Die Metallschicht ist dabei außerdem in einem ersten Fall fest mit einer Leiterbrücke verbunden, die ihrerseits fest mit zumindest einem thermoelektrischen Element verbunden ist. In einem zweiten Fall ist die Metallschicht dagegen so ausgeführt, dass sie selbst als Leiterbrücke dient und dementsprechend direkt mit zumindest einem thermoelektrischen Element verbunden ist.

Das Dielektrikum ist definitionsgemäß metallfrei und bildet einen effizienten elektrischen Isolator. Eine derartige, dielektrische Isolationsschicht lässt sich fest an der jeweiligen metallischen Außenwand anbringen. Ferner lässt sich an der Isolationsschicht die genannte Metallschicht fest anbringen, die sich ihrerseits dazu eignet, die Leiterbrücken oder die thermoelektrischen Elemente daran zu befestigen. Somit ergibt sich ein Aufbau für das thermoelektrische Modul, bei dem eine vergleichsweise dauerhafte, feste Verbindung zwischen den thermoelektrischen Elementen und der jeweiligen Außenwand geschaffen werden kann, die sich durch eine effiziente elektrische Isolationswirkung sowie durch eine relativ günstige Wärmeleitung auszeichnet. Des Weiteren lassen sich Beschichtungen regelmäßig serientauglich gestalten, so dass eine preiswerte Produktion der thermoelektrischen Module möglich ist.

Entsprechend einer vorteilhaften Ausführungsform ist die elektrische Isolationsschicht durch eine dielektrische Einbrennpaste gebildet, die beim Herstellen der Verbindung auf die jeweilige Außenwand aufgetragen und eingebrannt wird. Das "Einbrennen" ist dabei ein thermisches Verfahren, bei dem die Einbrennpaste auf eine Temperatur erhitzt wird, bei der sich Bestandteile der Einbrennpaste verflüssigen, während die jeweilige Außenwand weitgehend fest bleibt. Die verflüssigten Komponenten der Einbrennpaste können in Oberflächenrauigkeiten der Außenwand eindringen bzw. diese in die Isolationsschicht einbinden, wodurch sich nach dem Erstarren der Einbrennpaste nach dem Einbrennvorgang eine dauerhafte, thermisch strapazierfähige feste Verbindung zwischen der Isolationsschicht und der Außenwand ausbildet. Je nach Materialzusammensetzung der Einbrennpaste und der Außenwand können grundsätzlich auch Fusionsverbindungen oder fusionsartige Verbindungen generiert werden, was eine stoffschlüssige oder stoffschlussartige Verbindung zwischen Isolationsschicht und Außenwand ermöglicht. Von besonderem Vorteil ist dabei, dass eine derartige Einbrennpaste besonders einfach im Rahmen einer Großserienfertigung genutzt werden kann. Beispielsweise lässt sich eine derartige Einbrennpaste auf die Außenwand aufdrucken, beispielsweise durch ein Siebdruckverfahren. Eine dielektrische Einbrennpaste enthält neben den aufschmelzenden Bestandteilen auch Festkörperpartikel, die beim Einbrennen nicht aufschmelzen. Diese Festkörperpartikel bestehen aus einem elektrisch isolierenden Material. Hierbei handelt es sich vorzugsweise um nichtmetallischen Festkörperpartikeln, wie z.B. Keramikpartikel und/oder Glaspartikel.

Grundsätzlich kann die elektrisch leitende Metallschicht durch eine Metallisierung der Isolationsschicht gebildet sein. Eine derartige Metallisierung lässt sich beispielsweise durch unterschiedliche Verfahren der Dünnschichttechnik realisieren, beispielsweise durch eine physikalische Gasphasenabscheidung, zum Beispiel durch eine sogenannte Sputter-Deposition oder durch ein thermisches Verdampfen. Ferner lässt sich auch eine physikalische oder chemische Gasphasenabscheidung realisieren, sogenannte PVD- oder CVP-Verfahren, beispielsweise eine plasmaunterstützte chemische Gasphasenabscheidung. Ferner sind denkbar, die Metallisierung durch ein thermisches Spritzen oder durch ein Galvanisieren zu realisieren.

Bevorzugt ist jedoch eine Ausführungsform, bei welcher die elektrisch leitende Metallschicht durch eine metallische Einbrennpaste gebildet ist. Eine derartige metallische Einbrennpaste enthält neben den beim Einbrennvorgang aufschmelzenden Bestandteilen zusätzlich Festkörperpartikel, vorzugsweise Metallpartikel, die beim Einbrennen nicht aufschmelzen und die für die elektrische Leitfähigkeit der Metallschicht sorgen. Auch hier sorgt das Einbrennen der Einbrennpaste für eine besonders feste und dauerhafte Verbindung der Metallschicht mit der Isolationsschicht. Durch eine entsprechende, komplementäre Auswahl der Komponenten bzw. Bestandteile, die sich in der jeweiligen Einbrennpaste verflüssigen, lässt sich eine besonders feste Verbindung zwischen der Metallschicht und der Isolationsschicht erzielen. Besonders vorteilhaft lassen sich die aufschmelzenden Materialien so aufeinander abstimmen, dass eine Fusionsverbindung zwischen der Metallschicht und der Isolationsschicht entsteht, also eine Stoffschlussverbindung. Sofern sowohl die Isolationsschicht mittels einer dielektrischen Einbrennpaste als auch die Metallschicht mittels einer metallischen Einbrennpaste realisiert werden, ist denkbar, die sich in den Pasten verflüssigenden Bestandteile so aufeinander abzustimmen, dass sie beim Einbrennen der Metallschicht miteinander verschmelzen, sich also stoffschlüssig bzw. chemisch miteinander verbinden. Hierdurch wird die so generierte hochfeste Verbindung besonders unempfindlich gegenüber thermischen Wechselbelastungen.

Bevorzugt ist eine Ausführungsform, bei welcher die elektrische Isolationsschicht eine Schichtdicke von mindestens 20 µm aufweist. Die elektrische Isolationsschicht kann dabei grundsätzlich als einlagige Isolationsschicht konzipiert sein. Bevorzugt ist jedoch eine Ausführungsform, bei welcher die elektrische Isolationsschicht mehrlagig konzipiert ist. Denkbar ist beispielsweise, dass die Isolationsschicht aus zwei bis vier Lagen des Isolationsmaterials aufgebaut ist. Bevorzugt liegt die Schichtdicke der Isolationsschicht dann in einem Bereich von einschließlich 40 µm bis einschließlich 120 µm. Besonders vorteilhaft ist eine Ausführungsform, bei welcher die Schichtdicke der Isolationsschicht in einem Bereich von etwa 50 µm bis etwa 100 µm liegt.

Zusätzlich oder alternativ kann vorgesehen sein, dass die elektrisch leitende Metallschicht eine Schichtdicke von mindestens 5 µm aufweist. Auch hier ist denkbar, die Metallschicht einlagig auszuführen. Bevorzugt ist jedoch eine mehrlagige Struktur der Metallschicht. Sofern die Metallschicht nur zur Schaffung einer metallischen Anbindungsoberfläche auf der Isolationsschicht dient, die zum festen Verbinden mit einer separaten Leiterbrücke dient, kann dabei eine Schichtdicke von 10 µm bis 20 µm ausreichend sein. Soll die Metallschicht dagegen selbst als elektrisch leitende Leiterbrücke verwendet werden, ist eine Schichtdicke von 150 µm bis 300 µm von Vorteil. Sofern für die Isolationsschicht oder die Metallschicht eine mehrlagige Beschichtung vorgesehen wird, kann dies dadurch realisiert werden, dass die jeweilige Einbrennpaste entsprechend mehrlagig aufgetragen wird, wobei zweckmäßig nach jedem Auftrag zunächst ein Einbrennvorgang durchgeführt wird, bis die nächste Lage aufgetragen wird.

Gemäß einer anderen Ausführungsform kann das Dielektrikum durch ein polymerbasiertes oder durch ein glasbasiertes System mit nichtmetallischen Festkörperpartikeln, wie z.B. Keramikpartikeln und/oder Glaspartikeln, gebildet sein. Hierdurch lässt sich einerseits eine besonders effiziente mechanische Verbindung mit der metallischen Außenwand realisieren, während gleichzeitig eine ausreichende elektrische Isolation erzeugt werden kann. Die Polymerbasis bzw. die Glasbasis bildet dabei die aufschmelzende Komponente der dielektrischen Einbrennpaste.

Zur Verbesserung der Anhaftung der Isolationsschicht an der Außenwand kann es zweckmäßig sein, die Außenwand entsprechend aufzurauen, was durch mechanische Bearbeitung und/oder durch eine chemische Bearbeitung realisiert werden kann.

Bei einer anderen Ausführungsform kann die Metallschicht durch ein polymerbasiertes oder glasbasiertes System mit Metallpartikeln gebildet sein. Somit besitzt die Metallschicht eine hohe Kompatibilität zum vorstehend genannten Dielektrikum, was eine effiziente und dauerhafte Verbindung zwischen der Metallschicht und der Isolationsschicht ermöglicht.

Erfindungsgemäß wird eine separate Leiterbrücke verwendet, die einen Brückenkörper aus einer Metalllegierung auf Kupfer-Basis oder Nickel-Basis aufweist. Eine derartige Leiterbrücke lässt sich besonders einfach fest und dauerhaft mit der Metallschicht verbinden, wobei gleichzeitig eine hohe Wärmeleitfähigkeit sowie eine hohe elektrische Leitfähigkeit erreicht werden.

Erfindungsgemäß ist der aus einer Metalllegierung auf Kupfer-Basis oder Nickel-Basis hergestellte Brückenkörper zumindest an einer der Metallschicht zugewandten Seite, bevorzugt jedoch an seiner gesamten Außenseite, mit einer Beschichtung auf Silber-Basis und/oder Nickel-Basis versehen. Hierdurch lässt sich der Brückenkörper besonders einfach fest und dauerhaft mit der Metallschicht verbinden, beispielsweise durch ein Lötverfahren.

Bei einer anderen Ausführungsform kann vorgesehen sein, dass das jeweilige thermoelektrische Element einen Elementkörper aus einem thermoelektrisch aktiven Material aufweist. Hierbei handelt es sich je nach Position des thermoelektrischen Elements entweder um ein positiv dotiertes oder um ein negativ dotiertes Halbleitermaterial. Derartige thermoelektrisch aktive Materialien sind grundsätzlich bekannt. Besonders vorteilhaft ist nun eine Ausführungsform, bei welcher der Elementkörper zumindest im Bereich der Leiterbrücke mit einer Metallbeschichtung versehen ist. Hierdurch lässt sich das jeweilige thermoelektrische Element besonders einfach mit hoher Festigkeit an die jeweilige Leiterbrücke anbinden, die - wie mehrfach dargestellt - entweder durch eine separate Komponente oder durch eine entsprechend dick ausgeführte Metallschicht realisiert sein kann. Beispielsweise kann die Metallbeschichtung des Elementkörpers aus einer Legierung auf Titan-Basis oder auf Nickel-Basis oder auf Nickel-Bor-Basis oder auf Silber-Basis gebildet sein.

Bei einer anderen vorteilhaften Ausführungsform kann das thermoelektrische Element mittels Silber-Sinterung oder Hartlötung oder Weichlötung mit der separaten Leiterbrücke oder mit der als Leiterbrücke dienenden Metallschicht stoffschlüssig verbunden sein. Sinterverfahren und Lötverfahren eignen sich in besonderer Weise für eine Serienfertigung. Die damit erzielbaren stoffschlüssigen Verbindungen zeichnen sich durch eine hohe Dauerfestigkeit aus.

Gemäß einer anderen Ausführungsform kann die Außenwand mittels wenigstens eines Spalts segmentiert sein, wobei eine an der Außenseite der Außenwand angeordnete Metallfolie und/oder ein den jeweiligen Spalt dicht verschließendes Fugenmaterial vorgesehen sein können. Die Segmentierung der Außenwand führt zu einer mechanischen Entkopplung der einzelnen Segmente der Außenwand, so dass sich die einzelnen Segmente der Außenwand relativ zueinander verstellen können, was beispielsweise im Rahmen einer thermisch bedingten Ausdehnung erforderlich sein kann. Gleichzeitig wird durch die Segmentierung der Außenwand erreicht, dass die daran befestigten Leiterbrücken bzw. thermoelektrischen Elemente ebenfalls entsprechend der Segmentierung der Außenwand voneinander entkoppelt sind, so dass sie ebenfalls relativ zueinander beweglich sind. Auch diese Maßnahme verbessert die thermische Stabilität des thermoelektrischen Moduls.

Ein erfindungsgemäßes thermoelektrisches Modul zeichnet sich durch zwei Außenwände aus, die einen Modulinnenraum begrenzen und von denen die eine Außenwand eine Kaltseite des thermoelektrischen Moduls bildet, während die andere Außenwand eine Heißseite des thermoelektrischen Moduls bildet. Im Modulinnenraum weist das thermoelektrische Modul mehrere thermoelektrische Elemente auf, die mittels Leiterbrücken elektrisch verschaltet sind. Dabei ist zumindest ein derartiges thermoelektrisches Element mittels einer wärmeleitenden und elektrisch isolierenden Verbindung der vorstehend beschriebenen Art an wenigstens einer dieser Außenwände befestigt. Zweckmäßig sind alle thermoelektrischen Elemente mittels einer derartigen Verbindung an zumindest einer der Außenwände befestigt. Weiterhin ist bevorzugt vorgesehen, dass das jeweilige thermoelektrische Element an beiden Außenwänden jeweils mittels einer derartigen Verbindung befestigt ist. Besonders vorteilhaft ist daher eine Ausführungsform, bei der alle thermoelektrischen Elemente des thermoelektrischen Moduls über derartige Verbindungen der vorstehend beschriebenen Art einerseits mit der einen, die Kaltseite bildenden Außenwand und andererseits mit der anderen, die Heißseite bildenden Außenwand fest verbunden sind. Wie mehrfach erwähnt, sind die dabei vorgesehenen Leiterbrücken entweder in Form separater Komponenten in die jeweilige Verbindung eingebunden oder durch eine entsprechend dicke Metallschicht innerhalb der jeweiligen Verbindung realisiert.

Ein derartiges thermoelektrisches Modul kann grundsätzlich in Form eines separaten Bauteils realisiert sein, derart, dass die beiden Außenwände entlang eines umlaufenden Rands fest und dicht miteinander verbunden sind, wodurch der Modulinnenraum hermetisch verschlossen ist. Der Modulinnenraum kann dabei zweckmäßig evakuiert sein oder mit einem Inertgas gefüllt sein. Derartige, hermetisch gekapselte thermoelektrische Module lassen sich dann besonders einfach beispielsweise in einen Wärmeübertrager einbauen, über den eine Wärmequelle mit einer Wärmesenke thermisch gekoppelt ist. Beispielsweise enthält ein derartiger Wärmeübertrager Heizrohre, durch die ein Heizpfad zum Führen eines wärmeabgebenden Heizmediums geführt ist, sowie Kühlrohre, durch die ein Kühlpfad zum Führen eines wärmeaufnehmenden Kühlmediums geführt ist. Das jeweilige thermoelektrische Modul kann nun auf geeignete Weise zwischen einem solchen Heizrohr und einem solchen Kühlrohr angeordnet sein, zum Beispiel so, dass eine Außenseite des Heizrohrs die die Heißseite des thermoelektrischen Moduls bildende Außenwand berührt, während eine Außenseite des Kühlrohrs die die Kaltseite des thermoelektrischen Moduls bildende Außenwand berührt. Diese Berührung erfolgt bevorzugt direkt, kann jedoch auch über eine Wärmeleitpaste und dergleichen indirekt erfolgen. Ferner ist eine Ausführungsform für einen derartigen Wärmeübertrager denkbar, bei dem ein solches Heizrohr und/oder ein solches Kühlrohr eine Aussparung aufweist, in die das thermoelektrische Modul eingesetzt ist, derart, dass die die Heißseite des thermoelektrischen Moduls bildende Außenwand einen integrierten Abschnitt des Heizrohrs bildet, so dass die Außenwand im Betrieb des Wärmeübertragers unmittelbar mit dem wärmeabgebenden Heizmedium beaufschlagt ist. Zusätzlich oder alternativ kann das thermoelektrische Modul mit seiner die Kaltseite bildenden Außenwand in ein derartiges Kühlrohr eingesetzt sein, derart, dass diese Außenwand einen Abschnitt des Kühlrohrs bildet, so dass die Außenwand des thermoelektrischen Moduls im Betrieb des Wärmeübertragers direkt mit dem wärmeaufnehmenden Kühlmedium beaufschlagt ist.

Ein erfindungsgemäßes Verfahren zum Herstellen einer Verbindung der vorstehend beschriebenen Art, das entsprechend modifiziert auch zum Herstellen eines derartigen thermoelektrischen Moduls verwendet werden kann, zeichnet sich dadurch aus, dass zunächst eine elektrisch isolierende Isolationsschicht erzeugt wird, indem eine dielektrische Einbrennpaste auf die jeweilige Außenwand des thermoelektrischen Moduls aufgebracht und eingebrannt wird. Dies kann beispielsweise mittels eines Siebdruckverfahrens realisiert werden. Dies kann mehrfach wiederholt werden, um eine mehrlagige Isolationsschicht zu erzeugen. Optional kann für das Verfahren vorgesehen sein, eine elektrisch leitende Metallschicht zu erzeugen, indem eine metallische Einbrennpaste auf die Isolationsschicht aufgebracht und eingebrannt wird. Auch dies kann beispielsweise mittels eines Siebdruckverfahrens realisiert werden. Insbesondere lässt sich auch dieser Vorgang mehrfach hintereinander durchführen, um eine mehrlagige Metallschicht zu erzeugen. Des Weiteren kann optional vorgesehen sein, zumindest ein thermoelektrisches Element entweder direkt mit der Metallschicht, die dann als Leiterbrücke dient, oder indirekt über eine separate Leiterbrücke mit der Metallschicht mittels eines Sintervorgangs oder Lötvorgangs zu verbinden. Auch hier wird für die Verbindung des thermoelektrischen Elements mit der Leiterbrücke ein thermisches Verfahren verwendet. Wird eine separate Leiterbrücke verwendet, wird diese ebenfalls mittels eines Sintervorgangs oder eines Lötvorgangs mit der Metallschicht verbunden, während gleichzeitig das jeweilige thermoelektrische Element mittels desselben Sintervorgangs bzw. Lötvorgangs mit der Leiterbrücke verbunden wird. Somit ist nur ein Sintervorgang oder Lötvorgang erforderlich, um die jeweilige separate Leiterbrücke einerseits mit der Metallschicht und andererseits mit dem jeweiligen thermoelektrischen Element zu verbinden.

Weitere wichtige Merkmale und Vorteile der Erfindung ergeben sich aus den Unteransprüchen, aus der Zeichnung und aus der zugehörigen Figurenbeschreibung anhand der Zeichnung.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Bevorzugte Ausführungsbeispiele der Erfindung sind in der Zeichnung dargestellt und werden in der nachfolgenden Beschreibung näher erläutert.

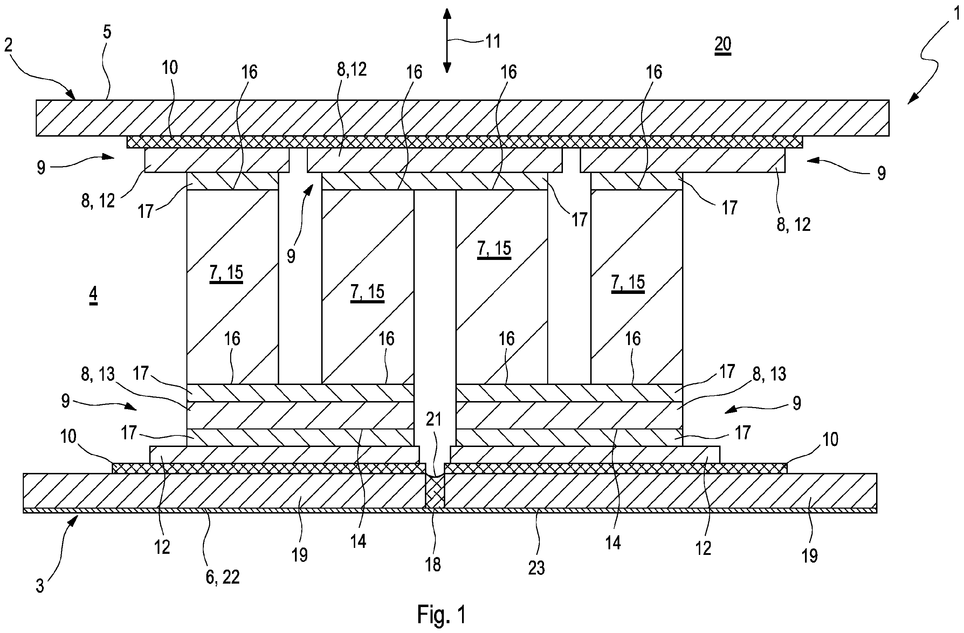

Die einzige Figur 1 zeigt einen Querschnitt durch einen Teil eines thermoelektrischen Moduls.

Entsprechend Fig. 1 umfasst ein hier nur teilweise dargestelltes thermoelektrisches Modul 1 zwei Außenwände 2, 3, die einen Modulinnenraum 4 begrenzen. Die eine Außenwand 2, zum Beispiel die in Fig. 1 oben gezeigte Außenwand 2, bildet eine Kaltseite 5 des thermoelektrischen Moduls 1. Die gegenüberliegende andere Außenwand 3, im Beispiel die in Fig. 1 unten gezeigte Außenwand 3, bildet eine Heißseite 6 des thermoelektrischen Moduls 1.

Das thermoelektrische Modul 1 weist außerdem mehrere thermoelektrische Elemente 7 auf, die im Modulinnenraum 4 angeordnet sind und mittels Leiterbrücken 8 elektrisch verschaltet sind. Die thermoelektrischen Elemente 7 sind dabei mit den beiden Außenwänden 2, 3 jeweils über eine elektrisch isolierende und wärmeleitende Verbindung 9 fest verbunden, welche die jeweilige Leiterbrücke 8 beinhaltet. Bevorzugt können diese Verbindungen 9 für beide Außenwände 2, 3 identisch ausgestaltet sein. In Fig. 1 ist jedoch zur Veranschaulichung ein Beispiel wiedergegeben, bei dem die Verbindungen 9 mit der oben gezeigten Außenwand 2 anders gestaltet sind als mit der unten gezeigten Außenwand 3. Die beiden Verbindungstypen unterscheiden sich durch die Art und Weise, wie die darin angeordnete Leiterbrücke 8 realisiert ist, was weiter unten genauer beschrieben ist.

Die jeweilige Verbindung 9 dient zum Befestigen eines derartigen thermoelektrischen Elements 7 an einer solchen Außenwand 2, 3. Hierzu umfasst die jeweilige Verbindung 9 eine elektrische Isolationsschicht 10, die mit der jeweiligen Außenwand 2, 3 fest verbunden ist. Die Isolationsschicht 10 ist dabei durch ein Dielektrikum gebildet. Bevorzugt ist die Isolationsschicht 10 durch eine dielektrische Einbrennpaste gebildet, die im Rahmen der Herstellung der jeweiligen Verbindung 9 auf die jeweilige Außenwand 2, 3 aufgetragen und eingebrannt worden ist. Beispielsweise ist das Dielektrikum durch ein polymerbasiertes oder glasbasiertes System mit Keramikpartikeln gebildet. Bevorzugt wird die Isolationsschicht 10 in einer Dickenrichtung 11 des thermoelektrischen Moduls 1, die in Fig. 1 durch einen Doppelpfeil angedeutet ist, mit einer Schichtdicke von mindestens 20 µm realisiert. Die Schichtdicke der Isolationsschicht 10 kann beispielsweise in einem Bereich von 40 bis 120 µm liegen. Bevorzugt ist eine Schichtdicke von 75 bis 100 µm. Sofern die Isolationsschicht 10 mehrlagig konzipiert ist, besitzt die einzelne Lage eine Schichtdicke von etwa 25 µm, wobei Abweichungen von maximal 5 µm in der einen und in der anderen Richtung zulässig sind.

Die Dickenrichtung 11 erstreckt sich senkrecht zu den als ebene Platten ausgestalteten Außenwänden 2, 3.

Die jeweilige Verbindung 9 umfasst außerdem eine elektrisch leitende Metallschicht 12, die im Bereich der jeweiligen Leiterbrücke 8 auf die Isolationsschicht 10 aufgebracht und damit fest verbunden ist. Auch hier ist eine Ausführungsform bevorzugt, bei der die elektrisch leitende Metallschicht 12 durch eine metallische Einbrennpaste gebildet ist, die im Rahmen der Herstellung auf die Isolationsschicht 10 aufgetragen und eingebrannt worden ist. Zweckmäßig wird auch hier eine Variante bevorzugt, bei der die Metallschicht 12 durch ein polymerbasiertes oder glasbasiertes System mit Metallpartikeln gebildet ist. Auch hier kommt eine einlagige oder mehrlagige Applikation der Metallschicht 12 in Frage. Eine in der Dickenrichtung 11 gemessene Schichtdicke der Metallschicht 12 beträgt dabei mindestens 5 µm. Grundsätzlich sind jedoch Schichtdicken von 10 bis 30 µm denkbar, wenn die Metallschicht 12 wie im Bereich der unteren Außenwand 3 zum Befestigen einer separaten Leiterbrücke 8 dient. Ebenso ist denkbar, die Metallschicht 12 mit einer größeren Schichtdicke, zum Beispiel mit einer Schichtdicke von 150 µm bis 300 µm zu realisieren, vor allem dann, wenn die Metallschicht 12 wie im Bereich der oberen Außenwand 2, selbst als Leiterbrücke 8 dienen soll. Somit unterscheiden sich die hier vorgestellten Verbindungstypen dadurch voneinander, dass bei dem der oberen Außenwand 2 zugeordneten Verbindungstyp die Leiterbrücken 8 nicht als separate Elemente vorgesehen sind, sondern durch entsprechende Abschnitte der Metallschicht 12, die dementsprechend dick ausgeführt ist, während bei dem der unteren Außenwand 3 zugeordneten Verbindungstyp separate Leiterbrücken 8 vorgesehen sind, die fest mit entsprechenden Abschnitten der Metallschicht 12 verbunden sind.

Ist wie in Fig. 1 unten innerhalb der jeweiligen Verbindung 9 eine separate Leiterbrücke 8 vorhanden, weist diese Leiterbrücke 8 zweckmäßig einen Brückenkörper 13 auf, der beispielsweise aus einer Metalllegierung auf Kupfer-Basis oder Silber-Basis oder Nickel-Basis beruht. Vorteilhaft handelt es sich um einen Brückenkörper 13 aus einer Metalllegierung auf Kupfer-Basis. Optional kann dieser Brückenkörper 13 zumindest auf einer der Metallschicht 12 zugewandten Außenseite sowie auf einer den thermoelektrischen Elementen 7 zugewandten Außenseite mit einer Metallbeschichtung 14 versehen sein, die beispielsweise auf einer Silber-Basis oder auf einer Nickel-Basis beruht.

Die thermoelektrischen Elemente 7 weisen jeweils einen Elementkörper 15 aus einem thermoelektrisch aktiven Material auf. Hierbei kann es sich um positiv dotierte sowie negativ dotierte Halbleitermaterialien handeln, die über die Leiterbrücken 8 entsprechend verschaltet sind. Um die Verbindung der thermoelektrischen Elemente 7 mit den Leiterbrücken 8 zu verbessern, können die Elementkörper 15 zumindest im Bereich der jeweiligen Leiterbrücke 8 mit einer Metallbeschichtung 16 versehen sein. Eine derartige Metallbeschichtung 16 kann auf einer Titan-Basis oder Nickel-Basis oder Nickel-Bor-Basis oder Silber-Basis beruhen.

Zur Befestigung der einzelnen thermoelektrischen Elemente 7 mit der jeweiligen Leiterbrücke 8 kann nun ein Sinterverfahren oder ein Lötverfahren herangezogen werden. Entsprechende Sinterschichten oder Lötschichten sind in Fig. 1 dabei mit 17 bezeichnet. Die jeweilige Sinterschicht 17 oder Lötschicht 17 kann dabei durch eine Silber-Sinterung oder durch eine Hartlötung, die mit Löttemperaturen oberhalb von 450°C erfolgt, oder durch eine Weichlötung erzeugt werden, die mit einer Löttemperatur unterhalb von 450°C erfolgt. Jedenfalls erzeugt die jeweilige Sinterschicht 17 oder Lötschicht 17 eine stoffschlüssige Verbindung zwischen dem thermoelektrischen Element 7 und der jeweiligen Leiterbrücke 8. Sofern wie in Fig. 1 bei der oberen Außenwand 2 die Leiterbrücke 8 durch eine entsprechend dicke Metallschicht 12 realisiert ist, ist nur eine Sinterschicht 17 bzw. Lötschicht 17 erforderlich, um das thermoelektrische Element 7 unmittelbar mit der Metallschicht 12 zu verbinden. Ist dagegen wie in Fig. 1 bei der unteren Außenwand 3 eine separate Leiterbrücke 8 vorgesehen, kommen zweckmäßig zwei derartige Sinterschichten 17 bzw. Lötschichten 17 zum Einsatz, nämlich, um die jeweilige separate Leiterbrücke 8 einerseits mit den thermoelektrischen Elementen 7 und andererseits mit der Metallschicht 12 zu verbinden.

In Fig. 1 ist rein exemplarisch nur für die untere Außenwand 3 eine optionale Segmentierung der Außenwand 3 wiedergegeben, die mittels wenigstens eines Spalts 18 realisiert ist. Sofern eine derartige Segmentierung der Außenwände 2, 3 in Betracht kommt, werden bevorzugt, jedoch nicht zwingend, beide Außenwände 2, 3 segmentiert. Der Spalt 18 durchdringt die jeweilige Außenwand 3 in der Dickenrichtung 11 vollständig, wodurch die Außenwand 3 in voneinander entkoppelte Außenwandsegmente 19 unterteilt ist. Um dennoch den Modulinnenraum 4 von einer Umgebung 20 des thermoelektrischen Moduls 1 trennen zu können, kann der jeweilige Spalt 18 beispielsweise durch ein Fugenmaterial 21 verschlossen sein. Das Fugenmaterial 21 ist elastisch und kann variierende Spaltbreiten kompensieren, die durch thermisch bedingte Dehnungsbewegungen der beiden Außenwandteile 19 relativ zueinander entstehen können. Zusätzlich oder alternativ kann an einer vom Modulinnenraum 4 abgewandten Außenseite 22 der segmentierten Außenwand 3 eine Metallfolie 23 angeordnet sein, welche den jeweiligen Spalt 18 verschließt.

Zusammengefasst lässt sich eine derartige Verbindung 9 bzw. ein damit ausgestattetes thermoelektrisches Modul 1 besonders einfach dadurch herstellen, dass auf die jeweilige Außenwand 2 bzw. 3 zunächst die Isolationsschicht 10 aufgebracht wird, indem, zum Beispiel mittels Siebdruck, eine dielektrische Einbrennpaste auf die jeweilige Außenwand 2 bzw. 3 aufgebracht und eingebrannt wird. Dieser Vorgang kann mehrfach wiederholt werden, wenn eine mehrlagige Konfiguration für die Isolationsschicht 10 erwünscht ist. Anschließend kann die Metallschicht 12 aufgebracht werden, indem eine metallische Einbrennpaste auf die Isolationsschicht 10 aufgebracht und eingebrannt wird. Auch hier kann dieser Vorgang mehrfach wiederholt werden, um bei Bedarf eine mehrlagige Metallschicht 12 zu erzeugen. Eine mehrlagige Metallschicht 12 kommt insbesondere dann in Betracht, wenn die Metallschicht 12 so dick ausgeführt werden soll, dass sie selbst als Leiterbrücke 8 dient, wie im Beispiel der oberen Außenwand 2 gezeigt.

Nach dem Anbringen der Metallschicht 12 können die thermoelektrischen Elemente 7 ggf. mit den separaten Leiterbrücken 8 in Verbindung mit einer entsprechenden Beschichtung mit Sintermaterial oder Lötmaterial angesetzt werden und anschließend gesintert bzw. gelötet werden.

## Patentansprüche

1. Wärmeleitende und elektrisch isolierende Verbindung zum Befestigen eines thermoelektrischen Elements (7) an einer Außenwand (2, 3), die eine Kaltseite (5) oder eine Heißseite (6) eines thermoelektrischen Moduls (1) bildet, das in einem Modulinnenraum (4) mehrere solche thermoelektrischen Elemente (7) aufweist,
- wobei die Verbindung (9) eine elektrische Isolationsschicht (10) aufweist, die mit der Außenwand (2, 3) fest verbunden ist und die durch ein Dielektrikum gebildet ist,
- wobei die Verbindung (9) eine elektrisch leitende Metallschicht (12) aufweist, die mit der Isolationsschicht (10) fest verbunden ist,
- wobei das thermoelektrische Element (7) mit einer mit der Metallschicht (12) fest verbundenen separaten Leiterbrücke (8) zum elektrischen Verbinden des thermoelektrischen Elements (7) mit wenigstens einem weiteren thermoelektrischen Element (7) innerhalb des thermoelektrischen Moduls (1) elektrisch leitend und fest verbunden ist,
- wobei die Leiterbrücke (8) einen Brückenkörper (13) aus einer Metalllegierung auf Kupfer-Basis oder Nickel-Basis aufweist, und
- wobei der Brückenkörper (13) mit einer Beschichtung (14) auf Silber-Basis und/oder Nickel-Basis versehen ist,
**dadurch gekennzeichnet,**
- **dass** das Dielektrikum durch ein polymerbasiertes oder glasbasiertes System mit nichtmetallischen Festkörperpartikeln gebildet ist, und
- **dass** die Außenwand (2, 3) mittels wenigstens eines Spalts (18) segmentiert ist, wobei eine an der Außenseite (22) der Außenwand (2, 3) angeordnete Metallfolie (23) und/oder ein den jeweiligen Spalt (18) dicht verschließendes Fugenmaterial (21) vorgesehen ist/sind.

2. Verbindung nach Anspruch 1,
**dadurch gekennzeichnet,**
**dass** die elektrische Isolationsschicht (10) durch eine dielektrische Einbrennpaste gebildet ist.

3. Verbindung nach Anspruch 1 oder 2,
**dadurch gekennzeichnet,**
**dass** die elektrisch leitende Metallschicht (12) durch eine metallische Einbrennpaste gebildet ist.

4. Verbindung nach einem der Ansprüche 1 bis 3,
**dadurch gekennzeichnet,**
- **dass** die elektrische Isolationsschicht (10) eine Schichtdicke von mindestens 20 µm aufweist, und/oder
- **dass** die elektrisch leitende Metallschicht (12) eine Schichtdicke von mindestens 5 µm aufweist.

5. Verbindung nach einem der Ansprüche 1 bis 4,
**dadurch gekennzeichnet,**
**dass** die Metallschicht (12) durch ein polymerbasiertes oder glasbasiertes System mit Metallpartikeln gebildet ist.

6. Verbindung nach einem der Ansprüche 1 bis 5,
**dadurch gekennzeichnet,**
**dass** das thermoelektrische Element (7) einen Elementkörper (15) aus einem thermoelektrisch aktiven Material aufweist, wobei der Elementkörper (15) zumindest im Bereich der Leiterbrücke (8) mit einer Metallbeschichtung (16) versehen ist.

7. Verbindung nach einem der Ansprüche 1 bis 6,
**dadurch gekennzeichnet,**
**dass** das thermoelektrische Element (7) mittels Silber-Sinterung oder Hartlötung oder Weichlötung mit der separaten Leiterbrücke (8) oder mit der Metallschicht (12) stoffschlüssig verbunden ist.

8. Thermoelektrisches Modul,
- mit zwei Außenwänden (2, 3), die einen Modulinnenraum (4) begrenzen und von denen die eine eine Kaltseite (5) des thermoelektrischen Moduls (1) bildet, während die andere eine Heißseite (6) des thermoelektrischen Moduls (1) bildet,
- mit mehreren thermoelektrischen Elementen (7), die im Modulinnenraum (4) angeordnet sind und die mittels Leiterbrücken (8) elektrisch verschaltet sind,
- wobei wenigstens ein solches thermoelektrisches Element (7) mittels einer wärmeleitenden und elektrisch isolierenden Verbindung (9) nach einem der Ansprüche 1 bis 7 an wenigstens einer der Außenwände (2, 3) befestigt ist.

9. Verfahren zum Herstellen einer Verbindung (9) nach einem der Ansprüche 1 bis 7 oder eines thermoelektrischen Moduls (1) nach Anspruch 8,
- bei dem eine elektrisch isolierende Isolationsschicht (10) erzeugt wird, indem eine dielektrische Einbrennpaste auf die jeweilige Außenwand (2, 3) aufgebracht und eingebrannt wird,
- bei dem eine elektrisch leitende Metallschicht (12) erzeugt wird, indem eine metallische Einbrennpaste auf die Isolationsschicht (10) aufgebracht und eingebrannt wird,
- bei dem zumindest ein thermoelektrisches Element (7) entweder direkt mit der Metallschicht (12), die dabei als Leiterbrücke (8) dient, oder indirekt über eine separate Leiterbrücke (8) mit der Metallschicht (12) mittels eines Sintervorgangs oder Lötvorgangs verbunden wird.

## Claims

1. Heat-conductive and electrically insulating connection for fastening a thermoelectric element (7) to an outer wall (2, 3), which forms a cold side (5) or a hot side (6) of a thermoelectric module (1), which has a plurality of such thermoelectric elements (7) in a module inner space (4),
- wherein the connection (9) has an electrical insulation layer (10), which is firmly connected to the outer wall (2, 3) and which is formed by a dielectric,
- wherein the connection (9) has an electrically conductive metal layer (12), which is firmly connected to the insulation layer (10),
- wherein the thermoelectric element (7) is connected in an electrically conductive and fixed manner to a separate conductor bridge (8) connected to the metal layer (12) in a fixed manner for electrically connecting the thermoelectric element (7) to at least one further thermoelectric element (7) inside the thermoelectric module (1),
- wherein the conductor bridge (8) has a bridge body (13) made of a copper-based or nickel-based metal alloy, and
- wherein the bridge body (13) is provided with a silver-based and/or nickel-based coating (14),
**characterised in that**
- the dielectric is formed by a polymer-based or glass-based system with non-metallic solid particles, and
- the outer wall (2, 3) is segmented by at least one gap (18), wherein a metal foil (23) arranged on the outside (22) of the outer wall (2, 3) and/or a jointing material (21) tightly closing the particular gap (18) is/are provided.

2. Connection according to claim 1,
**characterised in**
**that** the electrical insulation layer (10) is formed by a dielectric stoving paste.

3. Connection according to claim 1 or 2,
**characterised in**
**that** the electrically conductive metal layer (12) is formed by a metallic stoving paste.

4. Connection according to any one of claims 1 to 3,
**characterised in**
- **that** the electrical insulation layer (10) has a layer thickness of at least 20 µm and/or
- **that** the electrically conductive metal layer (12) has a layer thickness of at least 5 µm.

5. Connection according to any one of claims 1 to 4,
**characterised in**
**that** the metal layer (12) is formed by a polymer-based or glass-based system with metal particles.

6. Connection according to any one of claims 1 to 5,
**characterised in**
**that** the thermoelectric element (7) has an element body (15) of a thermoelectrically active material, wherein the element body (15) is provided with a metal coating (16) at least in the region of the conductor bridge (8).

7. Connection according to any one of claims 1 to 6,
**characterised in**
**that** the thermoelectric element (7) is materially bonded to the separate conductor bridge (8) or to the metal layer (12) by means of silver sintering or brazing or soft soldering.

8. Thermoelectric module,
- having two outer walls (2, 3), which delimit a module inner space (4), one of them forming a cold side (5) of the thermoelectric module (1), while the other forms a hot side (6) of the thermoelectric module (1),
- having a plurality of thermoelectric elements (7), which are arranged in the module inner space (4) and which are electrically interconnected by means of conductor bridges (8),
- wherein at least one such thermoelectric element (7) is fastened to at least one of the outer walls (2, 3) by means of a heat-conductive and electrically insulating connection (9) according to any one of claims 1 to 7.

9. Method for producing a connection (9) according to any one of claims 1 to 7 or a thermoelectric module (1) according to claim 8,
- in which an electrically insulating insulation layer (10) is created through the application of a dielectric stoving paste onto the particular outer wall (2, 3) and stoving of said paste,
- in which an electrically conductive metal layer (12) is created through the application of a metallic stoving paste onto the insulation layer (10) and stoving of said paste,
- in which at least one thermoelectric element (7) is connected either directly to the metal layer (12), which in this connection severs as conductor bridge (8), or indirectly by way of a separate conductor bridge (8) to the metal layer (12) by means of a sintering process or soldering process.

## Revendications

1. Liaison conductrice et électriquement isolante pour fixer un élément thermoélectrique (7) à une paroi extérieure (2, 3), qui forme un côté froid (5) ou un côté chaud (6) d'un module thermoélectrique (1), qui comporte dans un espace intérieur de module (4) plusieurs éléments thermoélectriques (7) de ce type,
- dans laquelle la liaison (9) comporte une couche d'isolation électrique (10), qui est reliée de manière fixe à la paroi extérieure (2, 3) et qui est formée par un diélectrique,
- dans laquelle la liaison (9) comporte une couche métallique électriquement conductrice (12), qui est reliée de manière fixe à la couche d'isolation (10),
- dans laquelle l'élément thermoélectrique (7) est relié de manière fixe et de manière électrique conductrice à un pont conducteur séparé (8), relié de manière fixe à la couche métallique (12), en vue de la liaison électrique de l'élément thermoélectrique (7) avec au moins un autre élément thermoélectrique (7) à l'intérieur du module thermoélectrique (1),
- dans laquelle le pont conducteur (8) comporte un corps de pont (13) en un alliage métallique à base de cuivre ou à base de nickel, et
- dans lequel le corps de pont (13) est muni d'un revêtement (14) à base d'argent et/ou à base de nickel,
**caractérisée en**
- **ce que** le diélectrique est formé par un système à base de polymère ou à base de verre avec des particules solides non métalliques, et
- ce que la paroi extérieure (2, 3) est segmentée au moyen d'au moins une fente (18), une feuille métallique (23) qui est agencée au niveau du côté extérieur (22) de la paroi extérieure (2, 3) et/ou un matériau de jointoiement (21) qui ferme de manière étanche la fente respective (18) étant prévus.

2. Liaison selon la revendication 1,
**caractérisée en**
**ce que** la couche d'isolation électrique (10) est formée par une pâte à cuire diélectrique.

3. Liaison selon la revendication 1 ou 2,
**caractérisée en**
**ce que** la couche métallique électriquement conductrice (12) est formée par une pâte à cuire métallique.

4. Liaison selon l'une quelconque des revendications 1 à 3,
**caractérisée en**
- **ce que** la couche d'isolation électrique (10) comporte une épaisseur de couche d'au moins 20 µm, et/ou
- ce que la couche métallique électriquement conductrice (12) comporte une épaisseur de couche d'au moins 5 µm.

5. Liaison selon l'une quelconque des revendications 1 à 4,
**caractérisée en**
**ce que** la couche métallique (12) est formée par un système à base de polymère ou à base de verre avec des particules métalliques.

6. Liaison selon l'une quelconque des revendications 1 à 5,
**caractérisée en**
**ce que** l'élément thermoélectrique (7) comporte un corps d'élément (15) en un matériau actif du point de vue thermoélectrique, le corps d'élément (15) étant muni d'un revêtement métallique (16) au moins dans la zone du pont conducteur (8).

7. Liaison selon l'une quelconque des revendications 1 à 6,
**caractérisée en**
**ce que** l'élément thermoélectrique (7) est relié par liaison de matière au pont conducteur séparé (8) ou à la couche métallique (12) au moyen d'un frittage d'argent ou d'un brasage fort ou d'un brasage tendre.

8. Module thermoélectrique,
- avec deux parois extérieures (2, 3), qui délimitent un espace intérieur de module (4) et dont l'une forme un côté froid (5) du module thermoélectrique (1) tandis que l'autre forme un côté chaud (6) du module thermoélectrique (1),
- avec plusieurs éléments thermoélectriques (7), qui sont agencés dans l'espace intérieur de module (4) et qui sont connectés électriquement au moyen de ponts conducteurs (8),
- dans lequel au moins un élément thermoélectrique (7) de ce type est fixé à au moins l'une des parois extérieures (2, 3) au moyen d'une liaison conductrice de chaleur et électriquement isolante (9) selon l'une quelconque des revendications 1 à 7.

9. Procédé de fabrication d'une liaison (9) selon l'une quelconque des revendications 1 à 7 ou d'un module thermoélectrique (1) selon la revendication 8,
- dans lequel on produit une couche d'isolation électriquement isolante (10) en appliquant une pâte à cuire diélectrique sur la paroi extérieure respective (2, 3) et en la faisant cuire,
- dans lequel on produit une couche métallique électriquement conductrice (12) en appliquant une pâte à cuire métallique sur la couche d'isolation (10) et en la faisant cuire,
- dans lequel, au moyen d'une opération de frittage ou de brasage, on relie au moins un élément thermoélectrique (7) soit directement à la couche métallique (12), qui sert alors de pont conducteur (8), soit indirectement via un pont conducteur séparé (8) à la couche métallique (12).
